# DEMANDE DE BREVET EUROPEEN

(11) **EP 4 624 913 A1**
(43) Date de publication de la demande: **01.10.2025**
(21) Numéro de dépôt: 25165545.2
(22) Date de dépôt: 24.03.2025
(51) Int. Cl.: G01N 27/04, G01R 27/08

(54) **DISPOSITIF DE MESURE DE LA CONDUCTIVITE APTE A FONCTIONNER A HAUTE TEMPERATURE**

(30) Priorité: 29.03.2024 FR 2403307
(71) Demandeur: SAFRAN, 75015 Paris (FR); Centre National de la Recherche Scientifique, 75016 Paris (FR); UNIVERSITE DE BORDEAUX, 33000 Bordeaux (FR); INSTITUT POLYTECHNIQUE DE BORDEAUX, 33400 Talence (FR)
(72) Inventeur: CAVARROC, Marjorie, Christine, 77550 MOISSY-CRAMAYEL (FR); POULON, Angéline Nadine Jeanne, 33460 ARSAC (FR); MAUVY, Fabrice Claude Michel, 33610 CANEJAN (FR)
(74) Mandataire: Cabinet Beau de Loménie

(57) **Abrégé**

L'invention concerne un dispositif de mesure 100 de la conductivité apte à réaliser une mesure de conductivité à une température supérieure ou égale à 1500°C, le dispositif comprenant :
- un substrat 120 réfractaire et électriquement isolant ;
- quatre pistes conductrices 110a, 110b, 110c, 110d disposées sur une même surface du substrat, les pistes s'étendant chacune dans la même direction et étant chacune séparée des pistes voisines par une portion non conductrice du substrat, chacune des pistes comprenant du nitrure de tantale ou du nitrure de tantale dopé ;
- un organe de mesure 130, l'organe de mesure étant connecté électriquement à chacune des pistes du dispositif de mesure.

## Description

### Domaine Technique

Le présent exposé concerne un dispositif de mesure de la conductivité apte à fonctionner à haute température.

### Technique antérieure

L'augmentation de la température de fonctionnement des turbomachines aéronautiques permet une augmentation de leur rendement et donc des économies de carburant.

Néanmoins, l'augmentation des températures de fonctionnement soumet les matériaux constitutifs des turbomachines à des conditions plus agressives.

Le domaine aéronautique impose alors de certifier les pièces candidates à l'augmentation de la température, avant de pouvoir effectivement les utiliser pour des applications commerciales.

De telles certifications nécessitent de mesurer et de qualifier le comportement des pièces à certifier à haute température.

Il faut pour cela développer de nouveaux appareils qui eux-mêmes supportent la température de fonctionnement des pièces, et qui permettent à ces températures la mesure de leur comportement.

Ce dernier point pose un problème majeur dans le cas des dispositifs de mesure de la conductivité électrique.

De manière classique, pour des mesures réalisées à des températures allant jusqu'à 500°C, il a été proposé d'utiliser des alliages de cuivre, notamment des alliages de cuivre et d'étain, de cuivre et d'argent, de cuivre et de magnésium ou encore de cuivre et de chrome.

Toutefois, à des températures supérieures, il devient nécessaire d'utiliser des métaux nobles, notamment du platine, de l'or au de l'argent, mais leurs gammes d'utilisation sont inévitablement limitées par la température de fusion des alliages.

En outre, à cette complexité s'ajoute la particularité de l'environnement chimique d'une turbomachine dans lequel évoluent les dispositifs de mesure qui peuvent être source d'oxydes, délétères pour le bon fonctionnement des outils de mesure.

Il est donc indispensable de développer de nouveaux dispositifs de fonctionnement pouvant mesurer la conductivité à une température supérieure ou égale à 1500°C.

### Exposé de l'invention

L'invention vise précisément à proposer un dispositif de mesure de la conductivité apte à réaliser la mesure à une température supérieure à 1500°C.

Pour cela elle concerne selon un premier de ses aspects, un dispositif de mesure de la conductivité apte à réaliser une mesure de conductivité à une température supérieure ou égale à 1500°C, le dispositif comprenant :
- un substrat réfractaire et électriquement isolant ;
- quatre pistes conductrices disposées sur une même surface du substrat, les pistes s'étendant chacune dans la même direction et étant chacune séparée des pistes voisines par une portion non conductrice du substrat, chacune des pistes comprenant du nitrure de tantale ou du nitrure de tantale dopé ;
- un organe de mesure, l'organe de mesure étant connecté électriquement à chacune des pistes du dispositif de mesure.

Il est du mérite des inventeurs d'avoir déterminé que le nitrure de tantale et le nitrure de tantale dopé permettent de combiner d'une part une excellente mesure de la conductivité et d'autre part une excellente tenue à la température, et d'avoir su utiliser avantageusement ces propriétés dans le dispositif proposé.

Dans le dispositif, les quatre pistes conductrices comprenant du nitrure de tantale ou du nitrure de tantale dopé permettent de conduire le courant et cela même à une température supérieure à 1500°C. En outre, il faut noter que le nitrure de tantale ou le nitrure de tantale dopé n'est ni oxydé ni ne passe en forme liquide à de telles températures, et pas non plus dans l'environnement chimique que voient les pièces de turbomachines aéronautiques.

Enfin, pour la mesure de la conductivité en tant que telle, il suffit de disposer un échantillon dont on veut connaitre la conductivité de sorte qu'il intercepte les quatre pistes conductrices du dispositif.

Lorsqu'un échantillon est disposé de la sorte, et puisque le nitrure de tantale est conducteur et cela même à des températures supérieures ou égales à 1500°C, le dispositif et en particulier l'organe de mesure connecté électriquement aux quatre pistes conductrices, permet de réaliser un protocole de mesure de la conductivité connu, dit des 4 pointes (aussi appélée dans la littérature par la dénomination anglaise « 4 probes measurements method »).

Ces mesures permettent alors de déterminer la conductivité de l'échantillon.

Le dispositif est d'autant plus remarquable qu'il permet de réaliser la mesure de la conductivité de l'échantillon sans que l'organe de mesure lui-même ne doive être placé à la température de réalisation de la mesure.

En effet, l'organe de mesure est connecté électriquement aux pistes conductrices et ces dernières sont en contact de l'échantillon à la température souhaitée ce qui suffit pour mettre en place le protocole de mesure des quatre pointes.

On peut alors déporter les organes de mesure d'un dispositif dans une zone à plus basse température, mais le dispositif dans son ensemble permet néanmoins de mesurer la conductivité d'un échantillon à une température supérieure ou égale à 1500°C.

Dans un mode de réalisation, les pistes conductrices peuvent avoir une épaisseur inférieure ou égale à 20 µm.

Les inventeurs ont en effet constaté que la conductivité du nitrure de tantale était encore meilleure lorsque celui-ci était formulé sous la forme de couches dont l'épaisseur est conforme à celle indiquée.

Dans un mode de réalisation, l'espacement entre deux pistes conductrices côte-à-côte est compris entre 10 µm et 5 mm.

Un tel espacement permet une détermination optimale de la conductivité de l'échantillon en particulier dans la gamme d'intérêt comprise entre 0,01 et 10⁴ S/cm.

Dans un mode de réalisation, les pistes conductrices comprennent du nitrure de tantale de structure cristallographique hexagonale ou du nitrure de tantale dopé de structure cristallographique hexagonale.

Les inventeurs ont en effet déterminé que la conductivité du nitrure de tantale de structure cristallographique hexagonale était encore meilleure que celle du nitrure de tantale de structure cristallographique cubique.

Cette détermination a été faite sous air (mélange N₂/O₂), mais également sous d'autres atmosphères telles qu'une atmosphère d'argon (Ar), de dihydrogène (H₂) ou de leurs mélanges (Ar/H₂), ou des mélanges gazeux de type : CO/CO₂, CH₄, gaz humides (présence de vapeur d'eau H₂O).

Il s'ensuit un dispositif qui peut être utilisé sous différentes atmosphères représentatives des conditions d'opération réelles de l'échantillon dont on souhaite mesurer la conductivité.

Dans un mode de réalisation, les pistes conductrices comprennent pour plus de 95 % atomiques, voire pour plus de 99% atomiques, voire sont constituées de nitrure de tantale de tantale.

Dans un mode de réalisation, les pistes conductrices ne comprennent que du nitrure de tantale pour plus de 95% atomiques, le reste n'étant constitué que de dopants, par exemples choisis parmi les éléments choisis parmi les métaux alcalins, les métaux alcalino-terreux et/ou les métaux de transition.

Dans un mode de réalisation, les pistes conductrices sont en nitrure de tantale non dopé de structure cristallographique hexagonale.

Dans un mode de réalisation, les pistes conductrices sont en nitrure de tantale dopé de structure cristallographique hexagonale.

Quels que soient le dopant et la teneur en dopant, il est préférable que le nitrure de tantale dopé reste de structure cristallographique hexagonale.

En revanche, l'invention n'est pas limitée ni par la nature du dopant, ni par la quantité de ce dernier.

Dans un mode de réalisation, les pistes conductrices sont en nitrure de tantale dopé de structure cristallographique hexagonale, les pistes comprenant une teneur totale en dopant inférieure ou égale à 5 % atomique et le dopant étant choisi parmi les métaux alcalins, les métaux alcalino-terreux et/ou les métaux de transition ou un mélange de deux ou plus de ces éléments.

En d'autres termes, les pistes conductrices sont en nitrure de tantale dopé Ta₁₋ₓAₓN de structure cristallographique hexagonale avec A désignant un dopant correspondant à un ou plusieurs éléments choisis parmi les métaux alcalins, les métaux alcalino-terreux et/ou les métaux de transition avec x strictement positif et inférieur à 0,05.

La précision que x est strictement positif dans la définition qui précède n'entend aucunement exclure de l'invention des pistes conductrices en nitrure de tantale TaN non dopé, mais vise plutôt à éviter la redondance avec ce mode de réalisation décrit séparément.

Dans un mode de réalisation, le dopant peut être un ou plusieurs éléments choisis parmi les métaux alcalins, les métaux alcalino-terreux et/ou les métaux de transition.

Un tel dopant peut être choisi pour fonctionnaliser davantage les pistes conductrices, par exemple en augmentant la conductivité, la résistance à la corrosion ou en améliorant la stabilité de la phase cristalline hexagonale.

Dans un mode de réalisation, le dopant est un dopant unique choisi parmi les métaux alcalins, les métaux alcalino-terreux et/ou les métaux de transition.

Dans un mode de réalisation, le dopant peut être choisi parmi le potassium (K), le sodium (Na), le calcium (Ca), le magnésium (Mg), l'yttrium (Y), le vanadium (V), le titane (Ti) et un mélange d'un ou plusieurs de ces éléments.

Dans un mode de réalisation, le dopant est unique et choisi parmi le potassium (K), le sodium (Na), le calcium (Ca), le magnésium (Mg), l'yttrium (Y), le vanadium (V) et le titane (Ti).

Dans un mode de réalisation, la teneur en dopant est inférieure ou égale à 5 % atomique voir inférieure ou égale à 1,0 %.

Dans un mode de réalisation, la teneur en dopant est supérieure ou égale à 0,01 % atomique voire supérieure ou égale à 0,05 % atomique.

Par exemple, la teneur en dopant peut être comprise entre 0,01 % et 5,0 % atomique, voire entre 0,05 % et 5,0 % atomique, voire entre 0,1 et 1,0 % atomique.

En effet, cette teneur en dopant est une condition suffisante, mais pas nécessaire, pour assurer que la structure du nitrure de tantale reste hexagonale malgré la présence d'un dopant.

Dans un mode de réalisation, le revêtement de nitrure de tantale peut s'écrire Ta₁₋ₓAₓN avec A choisi parmi le potassium (K), le sodium (Na), le calcium (Ca), le magnésium (Mg), l'yttrium (Y), le vanadium (V), et le titane (Ti), et x compris entre 0 exclu et 0,05 inclus.

Dans un mode de réalisation, le substrat est constitué d'oxyde d'aluminium de nitrure d'aluminium ou d'un mélange de ces composés.

Dans un mode de réalisation, les pistes conductrices ont une longueur supérieure ou égale à 20 mm.

Dans un mode de réalisation, les pistes conductrices sont alignées et parallèles les unes aux autres.

Ce mode de réalisation facilite la détermination de la conductivité car la distance séparant deux pistes conductrices est alors aisément déterminable.

Selon un autre de ses aspects, l'invention concerne un procédé de détermination de la conductivité d'un échantillon à une température supérieure ou égale à 1500°C, le procédé comprenant au moins les étapes suivantes :
- la disposition de l'échantillon de sorte qu'il intercepte les quatre pistes conductrices d'un dispositif qui vient d'être décrit ;
- le chauffage de l'échantillon ainsi disposé à une température supérieure ou égale à 1500°C ;
- la détermination de la conductivité de l'échantillon par la méthode des quatre pointes, grâce à la détermination d'au moins une intensité entre deux des quatre pistes conductrices et d'une tension par l'organe de mesure entre les deux autres des pistes conductrices.

### Brève description des dessins

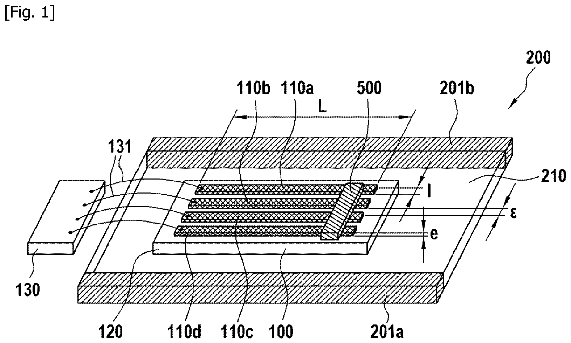

[Fig. 1] La figure 1 est une représentation schématique d'un dispositif de mesure dans un mode de réalisation de l'invention.

### Description des modes de réalisation

L'invention est décrite via une figure présente à but descriptif pour illustrer un mode de réalisation de l'invention et qui ne doit pas être interprétée comme limitant l'invention.

La figure 1 représente un dispositif 100 de mesure de la conductivité dans un mode de réalisation de l'invention, le dispositif étant ici disposé dans un four 200.

Le dispositif 100 comprend quatre pistes conductrices 110a, 110b, 110c et 110d, lesquelles sont ici rectangulaires, et parallèles les unes aux autres.

Dans un mode de réalisation, la longueur L des pistes conductrices 110a, 110b, 110c et 110d, peut être comprise entre 5 mm et 20 mm

Dans un mode de réalisation, la largeur l des pistes conductrices 110a, 110b, 110c et 110d, peut être comprise entre 2 mm et 5 mm.

Dans un mode de réalisation, l'épaisseur e des pistes conductrices 110a, 110b, 110c et 110d, peut être inférieure ou égale à 50 µm.

Il faut noter que l'épaisseur sur la figure 1 est représentée très largement supérieure à ce qu'elle n'est réellement, et cela pour favoriser la compréhension.

En effet, la conductivité du nitrure de tantale TaN ou du nitrure de tantale dopé est meilleure lorsque ce dernier est sous la forme d'une couche mince, ce qu'assure une épaisseur e telle que décrite.

Dans un mode de réalisation, l'espacement ε entre deux pistes conductrices 110a, 110b, 110c et 110d, peut être compris entre 10 µm et 5 mm.

Cet espacement permet une mesure optimale de la conductivité, en assurant le compromis entre les valeurs minimales qu'il est possible de mesurer et l'intensité ou la tension qu'il est nécessaire d'appliquer aux pistes conductrices 110a, 110b, 110c et 110d pour réaliser la mesure.

Ainsi que cela est décrit, le dispositif comprend un substrat 120, sur lequel sont disposées les quatre pistes conductrices 110a, 110b, 110c et 110d.

Les quatre pistes conductrices 110a, 110b, 110c et 110d ne sont pas connectées électriquement les unes aux autres au sens où la tension et/ou l'intensité de l'une d'entre elle n'affecte aucunement les autres. Bien entendu, dans un mode de fonctionnement du dispositif 100, elles seront chacune connectée à l'organe de mesure 130 pour les besoins de la détermination de la conductivité.

Par exemple, dans un mode de réalisation, les couches conductrices externes 110a et 110d permettent une mesure de l'intensité, tandis qu'une tension est mesurée entre les pistes conductrices internes 110b et 110c.

Le substrat 120 est réfractaire, au sens habituel du mot réfractaire à savoir qu'il n'a pas un comportement affecté par la température de mesure qui est supérieure ou égale à 1500°C.

Dans un mode de réalisation, le substrat 120 peut être en oxyde d'aluminium Al₂O₄ aussi dit alumine, ou en nitrure d'aluminium AIN.

De telles espèces présentent l'avantage d'être isolantes électriquement et de ne pas présenter de variations de dimensions délétères au dispositif décrit lorsqu'elles sont exposées à des températures supérieures ou égales à 1500°C.

Ainsi que cela est représenté sur la figure 1, l'échantillon 500 est placé de sorte qu'il intercepte les quatre pistes conductrices 110a, 110b, 110c et 110d.

Comme cela est représenté sur la figure 1, l'échantillon 500, le substrat 120 et les pistes conductrices 110a, 110b, 110c et 110d du dispositif 100 peuvent être disposées dans un four 200, lequel permet, par exemple via l'allumage de ses moyens de chauffage 201a, 201b d'amener l'échantillon ainsi que le substrat 120 et les pistes conductrices 110a, 110b, 110c et 110d du dispositif 100 à une température supérieure ou égale à 1500°C.

Ici, les moyens de chauffages 201a et 201b représentés sont résistifs mais cela n'est aucunement limitatif de l'invention.

Le dispositif 100 comprend en outre un organe de mesure 130, lequel est connecté électriquement aux pistes conductrices 110a, 110b, 110c et 110d du dispositif 200.

Par exemple, les pistes conductrices 110a, 110b, 110c et 110d peuvent être connectées électriquement à l'organe de mesure 130 via des fils 131.

Le fait d'avoir un organe de mesure 130 connecté électriquement aux pistes conductrices 110a, 110b, 110c et 110d du substrat 120 permet, ainsi que cela est figuré sur la figure 1, de déporter l'organe de mesure 130 en dehors de la zone chaude, ici du four 200.

Cette organisation particulière permet d'utiliser un organe de mesure 130 qui n'a pas de résistance particulière aux hautes températures, et de ne nécessiter des caractéristiques de résistance aux hautes températures que pour les pistes conductrices 110a, 110b, 110c et 110d cette résistance étant assurée par la composition des pistes conductrices en nitrure de tantale ou en nitrure de tantale dopé.

Cela diminue la complexité et le coût associé à l'organe de mesure 130 et donc du dispositif 100.

Dans un mode de réalisation, les pistes conductrices 110a, 110b, 110c et 110d du dispositif 100 peuvent être déposées par toute méthode permettant d'obtenir un dépôt de nitrure de tantale éventuellement dopé.

De préférence, la méthode de dépôt des pistes conductrices 110a, 110b, 110c et 110d sur le substrat 120 peut être une méthode de pulvérisation cathodique magnétron pulsé à haute puissance (désignée par l'acronyme « HiPIMS » dans la littérature en langue anglaise pour « High-Power Impulse Magnetron Sputtering »).

En contrôlant précisément les paramètres de dépôt d'une telle méthode il est en effet possible de garantir que le dépôt de nitrure de tantale soit de structure cristallographique hexagonale.

Des exemples de paramètres assurant l'obtention d'une telle structure cristallographique hexagonale est décrite dans le document US 2022/0349042.

Cela augmente encore davantage les propriétés de conductivités des pistes conductrices.

Dans un mode de réalisation, la détermination de la conductivité de l'échantillon par l'organe de mesure 130, électriquement connecté aux pistes conductrices 110a, 110b, 110c et 110d peut être réalisée au moyen de la méthode dite des quatre pointes.

Pour une telle méthode, l'organe de mesure 130 délivre une tension connue entre les pistes conductrices centrales 110b, 110c et un courant d'une intensité connue entre les pistes conductrices des extrémités 110a et 110d.

Le rapport de la tension mesurée sur l'intensité qui traverse l'échantillon 500 permet de déterminer la résistance entre les pistes centrales 110b et 110c.

En appliquant ensuite des approximations raisonnables ou en réalisant calcul intégral numérique tenant compte de la nature de l'échantillon 400 et de sa géométrie, la méthode permet alors d'accéder à la résistivité de l'échantillon 400. Par exemple, une méthode de détermination est décrite dans l'article intitulé « Dispositif automatique de mesure de réstivité entre 4 et 1100K » de Dordor et al., Revue de Physique appliquée, 1985.

## Revendications

1. Dispositif de mesure (100) de la conductivité apte à réaliser une mesure de conductivité à une température supérieure ou égale à 1500°C, le dispositif comprenant :
- un substrat réfractaire et électriquement isolant ;
- quatre pistes conductrices (110a, 110b, 110c, 110d) disposées sur une même surface du substrat, les pistes s'étendant chacune dans la même direction et étant chacune séparée des pistes voisines par une portion non conductrice du substrat, chacune des pistes comprenant du nitrure de tantale ou du nitrure de tantale dopé ;
- un organe de mesure (130), l'organe de mesure étant connecté électriquement à chacune des pistes du dispositif de mesure.

2. Dispositif de mesure (100) selon la revendication 1, dans lequel les pistes conductrices (110a, 110b, 110c, 110d) ont une épaisseur inférieure ou égale à 20 µm.

3. Dispositif de mesure (100) selon la revendication 1 ou 2, dans lequel les pistes conductrices (110a, 110b, 110c, 110d) comprennent du nitrure de tantale TaN de structure cristallographique hexagonale ou du nitrure de tantale dopé de structure cristallographique hexagonale.

4. Dispositif de mesure (100) selon la revendication 3, dans lequel les pistes conductrices (110a, 110b, 110c, 110d) sont en nitrure de tantale dopé de structure cristallographique hexagonale, les pistes conductrices comprenant une teneur totale en dopant inférieure ou égale à 5,0 % atomique et le dopant étant choisi parmi les métaux alcalins, les métaux alcalino-terreux et/ou les métaux de transition ou un mélange de deux ou plus de ces éléments.

5. Dispositif de mesure (100) selon la revendication 4, dans lequel le dopant est choisi parmi le potassium K, le sodium Na, le calcium Ca, le magnésium Mg, l'yttrium Y, le vanadium V, le titane Ti et un mélange d'un ou plusieurs de ces éléments.

6. Dispositif de mesure (100) selon la revendication 4 ou 5, dans lequel la teneur en dopant est comprise entre 0,01 % et 5,0 % atomique.

7. Dispositif de mesure (100) selon l'une quelconque des revendications 1 à 6, dans lequel le substrat (120) est constitué d'oxyde d'aluminium Al₂O₃, de nitrure d'aluminium AIN ou d'un mélange de ces composés.

8. Dispositif de mesure (100) selon l'une quelconque des revendications 1 à 7 dans lequel l'espacement (ε) entre deux pistes conductrices (110a, 110b, 110c, 110d) côte-à-côte est compris entre 10 µm et 5 mm.

9. Dispositif de mesure (100) selon l'une quelconque des revendications 1 à 8, dans lequel les pistes conductrices (110a, 110b, 110c, 110d) ont une longueur supérieure ou égale à 20 mm.

10. Procédé de détermination de la conductivité d'un échantillon à une température supérieure ou égale à 1500°C, le procédé comprenant au moins les étapes suivantes :
- la disposition de l'échantillon (500) de sorte qu'il intercepte les quatre pistes conductrices (110a, 110b, 110c, 110d) d'un dispositif selon l'une quelconque des revendications 1 à 9 ;
- le chauffage de l'échantillon ainsi disposé à une température supérieure ou égale à 1500°C ;
- la détermination de la conductivité de l'échantillon par la méthode des quatre pointes, grâce à la détermination d'au moins une intensité entre deux des quatre pistes conductrices et d'une tension par l'organe de mesure entre les deux autres des pistes conductrices.
